# EUROPEAN PATENT APPLICATION

(11) **EP 2 884 825 A1**
(43) Date of publication of application: **17.06.2015**
(21) Application number: 13275307.0
(22) Date of filing: 10.12.2013
(51) Int. Cl.: H05K 5/02, H02J 3/18, H02M 7/49, H02M 7/797, H05K 7/14, G06Q 10/08, G06K 17/00, G05B 19/042

(54) **Improvements in or relating to chain-link sub-modules**

(71) Applicant: ALSTOM Technology Ltd, 5400 Baden (CH)
(72) Inventor: Couch, Philip Robin, Honiton Devon EX14 9HG (GB); Stott, Timothy James, Stoke-on-Trent Staffordshire ST7 8JH (GB)
(74) Representative: Mitchell, Darren Andrew

(57) **Abstract**

In the field of voltage source converters, such as those used to transmit direct current (DC) power in static compensator (STATCOM) and static var compensator (SVC) systems, there is a need for an improved means of physically locating one or more chain-link sub-modules within a chain-link converter which minimises the risk of human error occurring, and so reduces the likelihood of a time-consuming visual inspection being required.

A chain-link sub-module (50), for providing a voltage source within a chain-link converter (60), comprises a reader module (52) which is operatively inter-connectable with a switching control unit (56) that is configured to, in use, control the chain-link sub-module (50). The chain-link sub-module (50) also includes a label member (58) which is preloaded with at least one electronically-readable location identifier that corresponds to the physical location of the chain-link sub-module (50) within a corresponding chain-link converter (60). The reader module (52) and the label member (58) are configured to communicate with one another whereby the reader module (52) is able electronically to read the at least one location identifier from the label member (58) and thereafter provide this information to an associated switching control unit (56).

## Description

This invention relates to a chain-link sub-module for providing a voltage source within a chain-link converter, and to a method of identifying the location of a chain-link sub-module within a chain-link converter.

One or more chain-links are often utilised in Voltage Source Converters (VSC), such as those used to transmit direct current (DC) power or in static compensator (STATCOM).

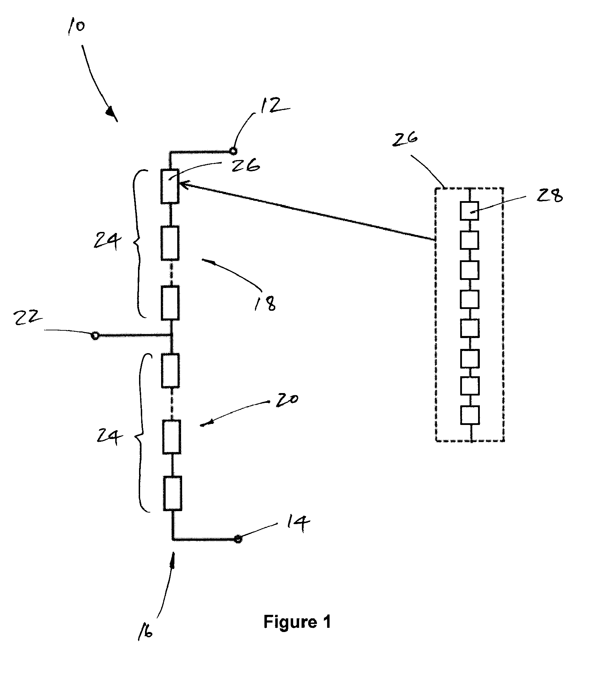

A typical voltage source converter is shown schematically in Figure 1. The voltage source converter 10 includes first and second DC terminals 12, 14 between which extends a converter limb 16. Other voltage source converters may include more than one converter limb 16 and, in particular, may include three converter limbs each of which corresponds to a given phase of a three-phase electrical power system.

The converter limb 16 includes first and second limb portions 18, 20 which are separated by an alternating current (AC) terminal 22.

In use the first and second DC terminals 12, 14 are respectively connected to positive and negative terminals of a DC network, and the AC terminal 22 is connected to an AC network.

Each limb portion 18, 20 includes a chain-link converter 24 which extends between the AC terminal 22 and a corresponding one of the first or the second DC terminal 12, 14. Each chain-link converter 24 includes a plurality of series connected chain-link modules 26, and each chain-link module 26 in turn includes a plurality of, e.g. eight, series connected chain-link sub-modules 28.

Each chain-link sub-module 28 includes a number of switching elements 30 which are connected in parallel with an energy storage device in the form of a capacitor 32. In the arrangements shown each switching element 30 includes a semiconductor device 34 in the form of, e.g. an Insulated Gate Bipolar Transistor (IGBT), which is connected in parallel with an anti-parallel diode 36. It is, however, possible to use other semiconductor devices.

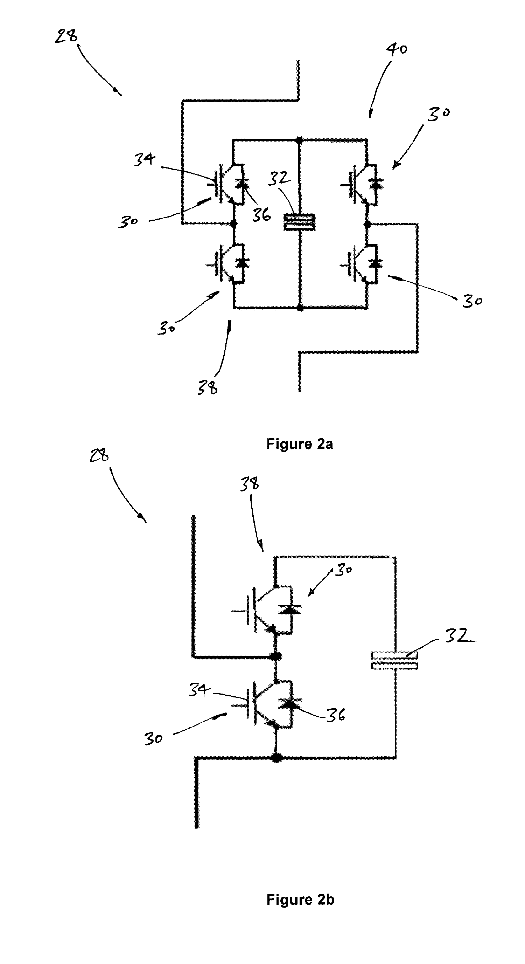

Figure 2(a) shows an example first chain-link sub-module 28 in which first and second pairs 38, 40 of switching elements 30 and a capacitor 32 are connected in a known full bridge arrangement to define a 4-quadrant bipolar module. Switching of the switching elements 30 selectively directs current through the capacitor 32 or causes current to bypass the capacitor 32 such that the first sub-module 28 can provide zero, positive or negative voltage and can conduct current in two directions.

Figure 2(b) shows an example second chain-link sub-module 28 in which only a first pair 38 of switching elements 30 is connected in parallel with a capacitor 32 in a known half-bridge arrangement to define a 2-quadrant unipolar module. In a similar manner to the first chain-link sub-module 28, switching of the switching elements 30 again selectively directs current through the capacitor 32 or causes current to bypass the capacitor 32 such that the second sub-module 28 can provide zero or positive voltage and can conduct current in two directions.

In this manner it is possible to build up a combined voltage across each chain-link module 26, via the insertion of the capacitors 32 of multiple chain-link sub-modules 28 (with each sub-module 28 providing its own voltage), which is higher than the voltage available from each individual sub-module 28.

Moreover, it is similarly possible to build up a combined voltage across each chain-link converter 24 by combining the individual voltage available from each chain-link module 26.

Accordingly, each of the chain-link modules 26 and its associated chain-link sub-modules 28 work together to permit the chain-link converter 24 to provide a stepped variable voltage source. This permits the generation of a voltage waveform across each chain-link converter 24 using a step-wise approximation. Operation of each chain-link converter 24 in this manner can be used to generate an AC voltage waveform at the AC terminal 22, and thereby enable the voltage source converter 10 to provide the aforementioned power transfer functionality between the AC and DC networks.

In order for the generated waveform to approximate an AC waveform to a desired extent it is often necessary for each chain-link converter 24 to include many hundred chain-link modules 26 and, in turn, typically several thousand chain-link sub-modules 28. Each sub-module 28 is often individually identifiable by way of a unique serial number which is created during manufacture of the sub-module 28 and typically is displayed on a serial number label affixed to an exterior of the sub-module 28.

From time to time the switching elements 30 and/or capacitor 32 in a chain-link sub-module 28 may fail such that it becomes necessary to repair or replace a given sub-module 28. Under such circumstances it then becomes necessary to physically locate the sub-module 28 within the associated chain-link converter 24. Since the operation of each sub-module 28 is independent of its location within a chain link convertor 24 there is no need for each sub-module to be aware of its physical location within the chain link convertor 24 in order to function normally. As a result no such sub-module 28 is able, automatically, to provide details of its physical location to e.g. an associated control system.

In addition, the very large number of such sub-modules 28 in, e.g. a typical voltage source converter 10, means that having a maintenance operator visually inspect each serial number label to identify a defective sub-module 28 is very time-consuming. This is especially so since the sub-modules 28 are normally inaccessible from ground level so as to ensure their respective isolation from ground.

It is not practical to pre-allocate a physical location of a sub-module 28 within such a chain-link converter 24, e.g. during manufacture of the sub-module, because vagaries in a manufacturer-to-site shipping process mean that a particular sub-module 28 may be delayed or damaged which might otherwise hold up on-going installation of the chain-link converter 24.

A number of attempts have been made to alleviate the aforementioned difficulty in physically locating a sub-module 28 within a chain-link converter 24.

One example is the creation, during installation of a chain-link converter 24, of an electronic or paper file in which the physical location of each sub-module 28 is recorded against its serial number.

Each sub-module 28 may also be locally programmed, e.g. by way of various switch settings, with its physical location as part of an initial installation process.

However, each of the foregoing attempted solutions requires a human operative to create and keep up to date the necessary physical location information. As such these processes are prone to human error, and so often it becomes necessary to carry out the time-consuming visual inspection mentioned above.

There is a need, therefore, for an improved means of physically locating one or more sub-modules within a chain-link converter which minimises the risk of human error occurring, and so reduces the likelihood of a time-consuming visual inspection being required.

According to a first aspect of the invention there is provided a chain-link sub-module, for providing a voltage source within a chain-link converter, comprising:
a reader module operatively inter-connectable with a switching control unit configured to, in use, control the chain-link sub-module; and
a label member pre-loaded with at least one electronically-readable location identifier corresponding to the physical location of the chain-link sub-module within a corresponding chain-link converter,
the reader module and the label member being configured to communicate with one another whereby the reader module is able electronically to read the at least one location identifier from the label member and thereafter provide this information to an associated switching control unit.

The inclusion of a label member which is pre-loaded with at least one electronically-readable location identifier corresponding to the physical location of the chain-link sub-module allows the chain-link sub-module to be quickly and simply configured with its physical location during, e.g. an initial installation phase.

Meanwhile the provision of a reader module which, in use, communicates with the label member, allows details of the aforementioned physical location of the chain-link sub-module to be readily obtained and conveyed, as required to, e.g. a switching control unit, without the need for any human intervention.

Accordingly, such features greatly reduce the risk of human error occurring, and so similarly reduce the likelihood of a time-consuming visual inspection being required.

Optionally the reader module and the label member are configured to communicate with one another via at least one of:
a radio frequency interface;
an electronic interface; and
an optical interface.

Each of the foregoing interface types provides a ready means of establishing a communication link between the reader module and the label member which requires little or no intervention by, e.g. a maintenance technician. As a result installation of the label member is fast and easy, e.g. during on-site installation of a voltage source converter.

Preferably the label member additionally includes a label member holder to position the label member relative to the reader module, the label member being selectively separable from the label holder.

The inclusion of a label member holder permits replacement of the label member, as required, e.g. in the event of the chain-link sub-module being moved to a different physical location within a corresponding chain-link converter, or in the event of a replacement chain-link sub-module being installed at an existing location within a chain-link converter such that the label member pre-loaded with the or each electronically-readable location identifier corresponding to the existing location should be configured to communicate with the reader module of the replacement chain-link sub-module.

The label member may include at least one visible location identifier readable by a maintenance technician.

Such an arrangement assists, e.g. a maintenance technician, in checking that individual label members of a plurality of chain-link sub-modules within a chain-link converter are arranged in the correct location and sequence.

In a preferred embodiment of the invention the label member includes a first visible location identifier corresponding to a given row within a chain-link converter in which the chain-link sub-module is located, and a second visible location identifier corresponding to a given column within a chain-link converter in which the chain-link sub-module is located.

Such a feature further assists in checking the correct placement of respective label members within, e.g. a chain-link converter.

Preferably the label member is additionally pre-loaded with an electronically-readable code corresponding to the or each visible location identifier.

The additional pre-loading of the label member with an electronically-readable code corresponding to the or each visible location identifier permits a chain-link sub-module firstly identified by its one or more visible location identifiers, e.g. by a human operative, to be readily also identified electronically by an associated switching control unit.

Furthermore, such functionality can also be used by, e.g. a maintenance technician, to cross-check the operative interconnection between the chain-link sub-module and the associated switching control unit.

According to a second aspect of the invention there is provided a method of identifying the location of a chain-link sub-module within a chain-link converter, the method comprising the steps of:
(a) providing the chain-link sub-module with a reader module operatively interconnected with a switching control unit configured to control the chain-link sub-module;
(b) arranging a label member adjacent to the reader module, the label member being pre-loaded with at least one electronically-readable location identifier corresponding to the physical location of the chain-link sub-module within the chain-link converter; and
(c) configuring the reader module and the label member to communicate with one another whereby the reader module is able electronically to read the at least one location identifier from the label member and thereafter provide this information to the associated switching control unit.

The method of the invention shares the advantages of the corresponding feature of the chain-link sub-module of the invention.

There now follows a brief description of preferred embodiments of the invention, by way of non-limiting example, with reference being made to the following figures in which:
Figure 1 shows a schematic view of a conventional voltage source converter including first and second chain-link converters;
Figure 2(a) shows a 4-quadrant bipolar sub-module which can form a part of each of the chain-link converters shown in Figure 1;
Figure 2(b) shows a 2-quadrant unipolar sub-module which can form a part of each of the chain-link converters shown in Figure 1;

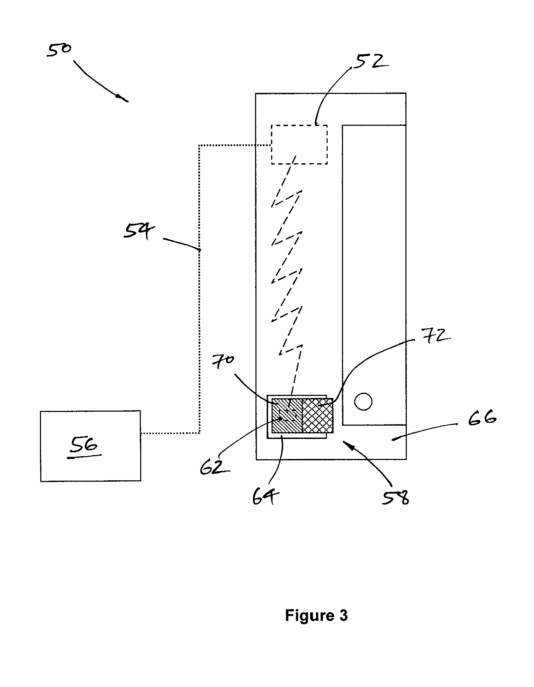

Figure 3 shows a schematic view of a chain-link sub-module according to a first embodiment of the invention; and
Figure 4 shows a schematic view of a plurality of the chain-link sub-modules shown in Figure 3 arranged as part of a chain-link converter.

A chain-link sub-module according to a first embodiment of the invention is designated generally by reference numeral 50.

The chain-link sub-module 50 includes a reader module 52 which, in use, is operatively interconnected, e.g. by a passive optical network 54, with a switching control unit 56 that controls the chain-link sub-module 50.

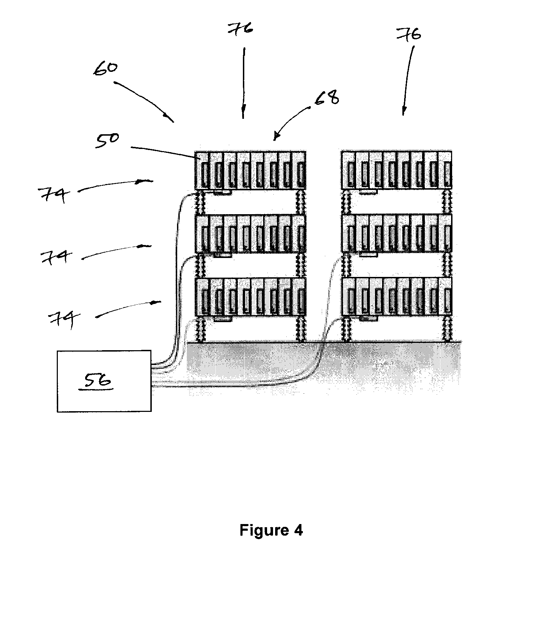

The chain-link sub-module 50 also includes a label member 58 which is pre-loaded with a plurality of location identifiers that correspond to the physical location of the sub-module 50 within a corresponding chain-link converter 60 (see Figure 4).

More particularly, in the embodiment shown the label member 58 takes the form of a planar, card-like member within which is located a radio frequency identification (RFID) tag 62 encoded with the plurality of location identifiers. The plurality of location identifiers correspond to the Cartesian coordinates of the chain-link sub-module 50 within the chain-link converter 60, i.e. the position of the chain-link sub-module 50 within mutually perpendicular x-, y-, and z- planes arranged with respect to the configuration of the chain-link converter 60. In other embodiments of the invention a different coordinate system may be employed, or the physical location of the chain-link sub-module may be characterised in a different manner.

The reader module 52 includes an RFID tag reader (not shown) and, as such, the reader module 52 and the label member 58 are able to communicate with one another via a radio frequency interface. Such an interface type advantageously permits reliable communication between the reader module 52 and the label member 58.

In other embodiments of the invention (not shown) the label member 58 may instead take the form of a planar, card-like member within which is located an electronic memory. The electronic memory stores the or each electronically-readable location identifier and the reader module 52 includes an electronic interface which is physically connectable to the electronic memory so as to permit reading of the location identifier information. In such an embodiment the reader module 52 and the label member 58 communicate with one another via an electronic interface.

In still further embodiments of the invention (not shown) the label member 58 may instead take the form of a planar, card-like member on which is located an optical code, e.g. a barcode, corresponding to the or each electronically-readable location identifier. The reader module 52 includes an optical reader which optically scans the optical code in order to read the location identifier information. In such an embodiment the reader module 52 and the label member 58 communicate with one another via an optical interface.

Returning to the first embodiment of the chain-link sub-module 50 shown in Figure 1, the label member 58 additionally includes a label member holder 64 to position the label member 58 relative to the reader module 52, as desired. In the embodiment shown the holder 64 is shown affixed to an outer housing 66 of the sub-module 50. In other embodiments of the invention, however, the holder 64 may be affixed elsewhere, e.g. on a structural member of the chain-link module 68 of which the sub-module 50 forms a part.

The label member 58, i.e. planar, card-like member, is selectively separable from the label member holder 64, such that the label member 58 may be removed from the chain-link sub-module 50.

In addition to the foregoing, the label member 58 also includes first and second visible location identifiers 70, 72, each of which is readable by a human operative. The first visible location identifier 70 corresponds to a given row 74 of the chain-link converter 60 in which the chain-link sub-module 50 is located, while the second visible location identifier 70 corresponds to a given column 76, i.e. "stack", of the chain-link converter 60.

In each instance the visible location identifier 70, 72 is a block of a particular colour.

However, in other embodiments of the invention one or more of the visible location identifiers 70, 72 may be or include a different visibly distinct marker, such as a text character or other symbol.

Furthermore, the RFID tag 62 is additionally pre-loaded with separate electronically-readable codes, each of which corresponds to one of the aforementioned visible location identifiers 70, 72.

In use, the reader module 52, i.e. the RFID tag reader therein, communicates via the radio frequency interface with the RFID tag 62 within the label member 58. Such communication may, for example, be initiated by the switching control unit 56 with which the reader module 52 is operatively interconnected. In any event, the reader module 52 reads the various location identifiers, and the codes corresponding to the visible location identifiers 70, 72, from the RFID tag 62.

Thereafter the reader module 52 conveys this information to the switching control unit 56 which is able to use the information to indicate to a maintenance operative, e.g. the Cartesian coordinates of the chain-link sub-module 50, whereby the maintenance operative is able to discern the exact physical location of the sub-module 50. As such the maintenance technician is able to proceed directly to the sub-module 50 to affect any necessary maintenance or repair.

## Claims

1. A chain-link sub-module, for providing a voltage source within a chain-link converter, comprising:
a reader module operatively inter-connectable with a switching control unit configured to, in use, control the chain-link sub-module; and
a label member pre-loaded with at least one electronically-readable location identifier corresponding to the physical location of the chain-link sub-module within a corresponding chain-link converter,
the reader module and the label member being configured to communicate with one another whereby the reader module is able electronically to read the at least one location identifier from the label member and thereafter provide this information to an associated switching control unit.

2. A chain-link sub-module according to Claim 1 wherein the reader module and the label member are configured to communicate with one another via at least one of:
a radio frequency interface;
an electronic interface; and
an optical interface.

3. A chain-link sub-module according to Claim 1 or Claim 2 wherein the label member additionally includes a label member holder to position the label member relative to the reader module, the label member being selectively separable from the label holder.

4. A chain-link sub-module according to any preceding claim wherein the label member includes at least one visible location identifier readable by a human operative.

5. A chain-link sub-module according to Claim 4 wherein the label member includes a first visible location identifier corresponding to a given row within a chain-link converter in which the chain-link sub-module is located, and a second visible location identifier corresponding to a given column within a chain-link converter in which the chain-link sub-module is located.

6. A chain-link sub-module according to Claim 4 or Claim 5 wherein the label member is additionally pre-loaded with an electronically-readable code corresponding to the or each visible location identifier.

7. A method of identifying the location of a chain-link sub-module within a chain-link converter, the method comprising the steps of:
(a) providing the chain-link sub-module with a reader module operatively interconnected with a switching control unit configured to control the chain-link sub-module;
(b) arranging a label member adjacent to the reader module, the label member being pre-loaded with at least one electronically-readable location identifier corresponding to the physical location of the chain-link sub-module within the chain-link converter; and
(c) configuring the reader module and the label member to communicate with one another whereby the reader module is able electronically to read the at least one location identifier from the label member and thereafter provide this information to the associated switching control unit.
